## Europäisches Patentamt

(19) **European Patent Office**

**Office européen des brevets**

(11) Publication number: **0 203 616**
**B1**

(12) **EUROPEAN PATENT SPECIFICATION**

(45) Date of publication of the patent specification: **02.08.89**

(51) Int. Cl.⁴: **C 23 C 16/44**

(21) Application number: **86107382.3**

(22) Date of filing: **30.05.86**

(54) **Chemical vapor deposition method for the thin film of semiconductor.**

(30) Priority: **31.05.85 JP 118378/85**

(43) Date of publication of application:
**03.12.86 Bulletin 86/49**

(45) Publication of the grant of the patent:
**02.08.89 Bulletin 89/31**

(84) Designated Contracting States:
**DE FR GB IT NL SE**

(56) References cited:
**EP-A-0 131 208**

(73) Proprietor: **THE FURUKAWA ELECTRIC CO., LTD.,**
**6-1, 2-chome, Marunouchi Chiyoda- ku, Tokyo (JP)**

(72) Inventor: **Kojima, Seiji, No. 17- 8, Takamatsu**
**1-chome, Nerima- ku Tokyo (JP)**
Inventor: **Ikeda, Masakiyo, No. 211, Ooguchi-**
**nakacho Kanagawa- ku, Yokohama- shi**
**Kanagawa- ken (JP)**
Inventor: **Kikuchi, Hiroshi, No. 14- 16, Yotsugi**
**1-chome Katsushika- ku, Tokyo (JP)**
Inventor: **Kashiwayanagi, Yuzo, No. 2-26, Yasuura-**
**cho, Yokosuka- shi Kanagawa- ken (JP)**

(74) Representative: **Patentanwälte TER MEER -**
**MÜLLER - STEINMEISTER, Mauerkircherstrasse**
**45, D-8000 München 80 (DE)**

## Description

### Background of the invention

The present invention relates to a method for the chemical vapor deposition of semiconductor thin films on a plurality of substrates fitted to the side faces of a susceptor in the shape of a frustum rotating in a vertical type reaction tube introducing the source gases and the carrier gas into said tube and heating the substrates to react with the source gases through thermal decomposition.

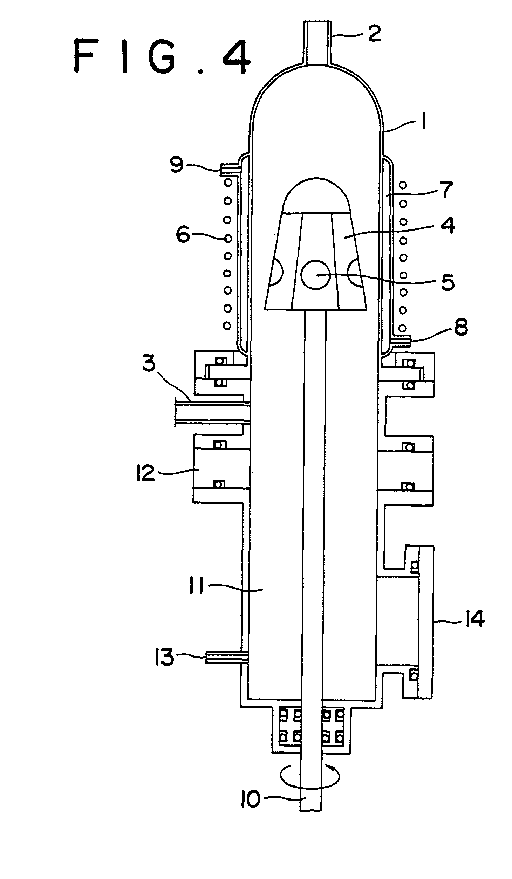

Generally, in the chemical vapor deposition method for the manufacture of semiconductor thin films, as shown in Fig. 4, a gas introductory port (2) and a gas exhaust port (3) are provided at the upper portion and the lower portion of a vertical type cylindrical reaction tube (1), respectively, a plurality of semiconductor substrates (5) are fitted onto the side faces of carbon susceptor (4) in the shape of polygonal frustum provided coaxially in the reaction tube (1), and the source gases and the carrier gas are introduced from the gas introductory port (2) at the upper portion to be flowed downwards and ejected from the exhaust port (3) at the lower portion. In this way, the substrates (5) are heated to a predetermied temperature to react with the source gases through thermal decomposition and the semiconductor thin films are deposited onto the substrates (5).

The substrates (5) are subjected to high-frequency heating by providing a RF coil (6) around the outer circumference of the reaction tube (1) and, in order to prevent the thermal decomposition of source gases except near the surface of the substrates (5), the reaction tube (1) is made double walled to form a jacket (7) having a refrigerant inductory port (8) and a refngerant exhaust port (9) and the refrigerant is flowed into this jacket (7) to cool the reaction tube (1). Moreover, in order to make the thickness ect. of the semiconductor thin film deposited uniform by averaging the discrepancy in the geometrical symmetry between the susceptor (4) and the reaction tube (1) and the discrepancy in the geometrical symmetry of the exhaust port (3), the susceptor (4) is rotated around the rotational axis (10) at a constant number of rotations. Besides, in the diagram, the numeral (11) indicates a preparation chamber to exchange the substrates (5) whereupon the semiconductor thin films are deposited, (12) indicates a gate valve, (13) indicates a hydrogen introductory port, and (14) indicates a flange for substrate loading.

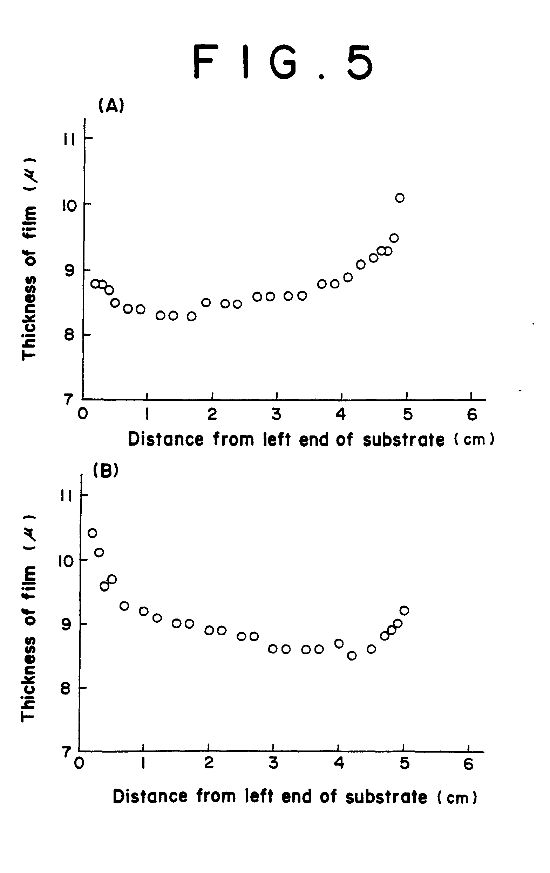

Although the variation in the thin films deposited may be considerably improved between the substrates by rotating of the susceptor at a constant number of rotations, in the conventional method for the chemical vapor deposition there is a shortcoming that the variation in the thin film in the perpendicular direction to the flow of gas is large in the substrate. Fig. 5 (A) and (B) show the variations in the thickness of thin films deposited in the perpendicular direction to the flow of gas by the conventional method for the chemical vapor deposition as described above, wherein (A) shows the case of the clockwise rotation and (B) shows that of the counter-clockwise rotation. It can be seen that the variations in the thickness of the film are large in all cases. Moreover, this dispersion becomes more remarkable, as the number of rotations of the susceptor increases.

### Summary of the invention

The object of the invention is a method for the chemical vapor deposition of semiconductor thin films on a plurality of substrates fitted to the side faces of a susceptor in the shape of a frustum rotating in a vertical type reaction tube by introducing the source gases and the carrier gas into said tube and heating the substrates to react with the source gases through thermal decomposition, characterized in that the speed of rotation of the susceptor is varied in terms of a rectangular wave function, trapezoidal wave function or a sine wave function and the susceptor is rotated in converse directions depending on the positive region and the negative region of the function, wherein the time for deposition is made equal to the cycle of the rectangular wave function, trapezoidal wave function or sine wave function multiplied by an integer, and N = K, wherein N is the sum of the number of rotations of the susceptor in the respective positive regions of the function and K is the number of converse rotations of the susceptor in the respective negative regions of the function.

One of the advantages of the present invention is that a chemical vapor deposition method for the manufacture of semiconductor thin films has been developed, which makes it possible to improve the uniformity of thin films simultaneously deposited from vapor phase onto a plurality of substrates between the substrates and in the substrates.

### Brief description of the drawing

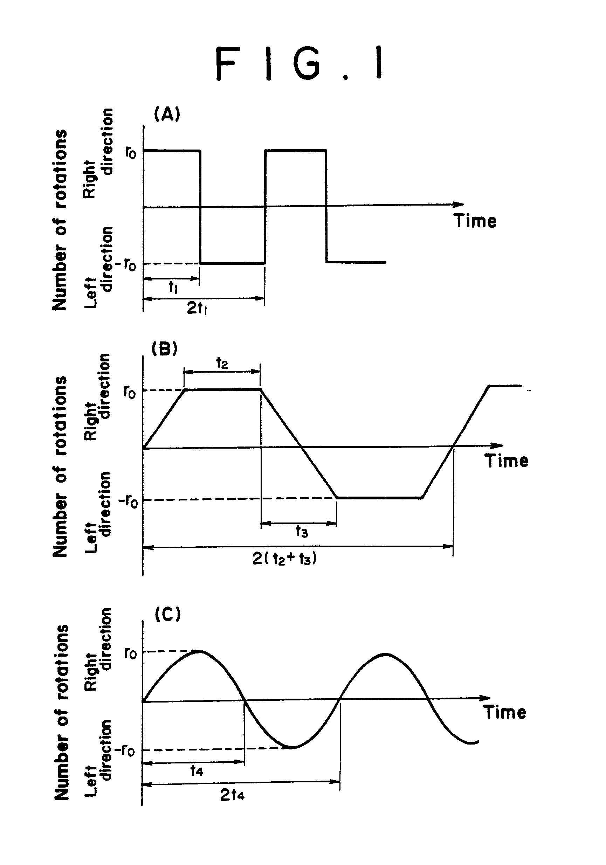

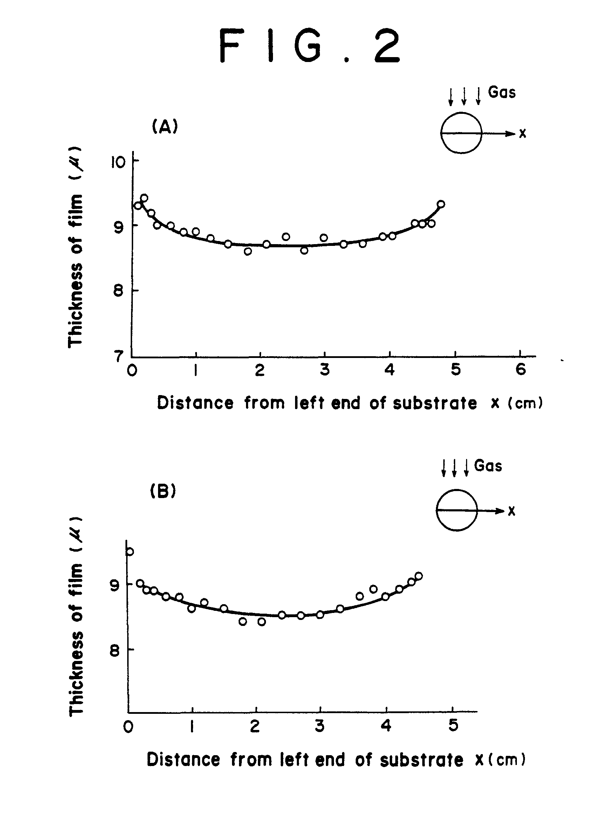

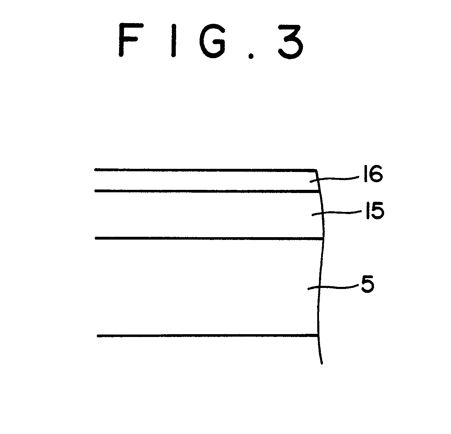

Fig. 1 (A), (B) and (C) are charts, wherein (A) shows a rotation in terms of rectangular wave function, (B) shows a rotation in terms of trapezoidal wave function and (C) shows a rotation in terms of sine wave function. Fig. 2 (A) and (B) show the variations in the thickness of thin films deposited from vapor phase according to the invention in the perpendicular direction to the flow of gas, wherein (A) is the case wherein the rotation of the susceptor is varied in terms of rectangular wave function and (B) is the case wherein the rotation of the susceptor is varied in terms of trapezoidal wave function. Fig. 3 is a cross-section showing one example wherein the buffer layer and the active layer are deposited in two layers onto the substrate. Fig. 4 is an illustration diagram showing one example of the chemical vapor deposition apparatus. Fig. 5 shows the variations in the thickness of thin films which are conventionally deposited from vapor phase in the perpendicular direction to the flow of gas. In Fig. 3 and Fig. 4, (1) is a reaction tube, (2) is a gas introductory port, (3) is a gas exhaust port, (4) is a susceptor, (5) is a substrate, (15) is a buffer layer, (16) is an active layer, (6) is a RF coil, (7) is a cooling jacket, and (10) is a rotational axis.

## Detailed description of the invention

In the invention, a plurality of semiconductor substrates are fitted to the side faces of a susceptor in the shape of a frustum provided coaxially in the vertical type reaction tube shown in Fig. 4 and the source gases and the carrier gas are introduced from the upper portion into the reaction tube to be flowed downwards and ejected from the exhaust port at the lower portion. In this way, the rotation of the susceptor is varied in terms of a rectangular wave function shown in Fig. 1 (A), trapezoidal wave function shown in Fig. 1 (B) or sine wave function shown in Fig. 1 (C), and the susceptor is rotatred in converse rotational directions depending on the positive region and the negative region of the function, for example, in clockwise rotation at the time of positive region and in counter-clockwise at the time of negative region as shown in Fig. 1 (A), (B) and (C). Then, the substrates fitted to the susceptor are heated and the semiconductor thin films are deposited onto the substrates.

When the direction of the rotation of the susceptor is varied to the converse rotational directions at the time of chemical vapor deposition, the uniformity in the thickness of film takes a state superposed the variation in the thickness of film in case of clockwise rotation shown in Fig. 5 (A) and that in case of counter-clockwise rotation shown in Fig. 5 (B), and, in particular, the uniformity in the central region except the end portions can be improved significantly. According to the invention, the rotation is varied in terms of the rectangular wave function, trapezoidal wave function or sine wave function as shown in Fig. 1 (A), (B) and (C) and the susceptor is rotated in converse directions depending on the positive region and the negative region of the function. Therefore, the uniformity of the thin film deposited from vapor phase onto the substrate can be improved still more inside the substrate.

In Fig. 1 (A), (B) and (C) the time constants ($t_1$ - $t_4$) and the speed of rotation ($r_0$) shown in the diagrams are determined depending on the thickness of the semiconductor thin film deposited and on the deposition rate. However, the speed of rotation $r_0$ is to be selected from the conditions under which the variation in the thickness of the thin film becomes less than $\pm$ 10 % when the direction of rotation is made constant. This is in a range of 3 to 10 rpm ordinarily in our case. Moreover, if the sum of the number of rotations $n_1$, $n_2$,..... $n_l$ of the susceptor is N times in the respective positive regions of the function and if the sum of the number of converse rotations $k_1$, $k_2$,.... $k_l$ of the susceptor is K times in the respective negative regions of the function, it is necessary to make N = K, and to make the time for the deposition of the semiconductor this film equal to the cycle of rectangular wave function, trapezoidal wave function or sine wave function multiplied by the integer.

## Example 1

Employing the chemical vapor deposition apparatus shown in Fig. 4 and using $AsH_3$ and $Ga(CH_3)_3$ for the source gases, the supplying ratio (V/III) thereof being at a rate of about 15, the rotations of the susceptor were varied in terms of rectangular wave function shown in Fig. 1 (A) and in terms of trapezoidal wave function shown in Fig. 1 (B), respectively, and the GaAs substrates having a diameter of 50 mm were heated to 650°C and the GaAs semicinductor thin film are deposited from vapor phase onto the substrates.

Besides, the variation in terms of the rectangular wave function is not desirable since the flow of gas is disturbed by the abrupt turning over of the rotational direction, but there is no difficulty if the time to be disturbed is shorter compared with the time of deposition. For this reason, it is desirable for $t_1$ to make longer than 60 seconds in the case of rectangular wave function shown in Fig. 1 (A).

In this example of the invention, the variations of the susceptor in terms of the rectangular wave function and the trapezoidal wave function were conducted under following conditions.

3

|  | Rectangular wave function | Trapezoidal wave function |
|---|---|---|
| Deposition rate ($\mu$m/min) | 0.087 | 0.087 |
| Thickness ($\mu$m) | 8.7 | 8.7 |
| Deposition time (min) | 100 | 100 |
| Time constant (min) | $t_1 = 10$ | $t_2 = 9$ |
|  |  | $t_3 = 1$ |
| Speed of rotation (rpm) | $r_0 = 6$ | $r_0 = 6$ |
| Number od rotations per a cycle (times) | 120 | 114 |
| Number of cycles | 5 | 5 |
| Total number of rotations | 600 | 570 |

Of the thin films thus obtained, the thickness of the film in the perpendicuilar to the flow of gas was examined. Results are shown in Fig. 2 (A) and (B).

Fig. 2 (A) shows the variation in the thickness of the film in the case of the susceptor being varied in terms of the rectangular wave function and Fig. 2 (B) shows that in the case of the susceptor being varied in terms of the trapezoidal wave function. As evident from the comparison with Fig. 5 (A) and (B), it can be seen that the dispersion in the thickness of the film at the central portion of 40 mm except the periphery of 5 mm is about $\pm$ 6 % by the conventional method, whereas it is improved to less than $\pm$ 3 % in accordance with the invention.

**Example 2**

Similarly to Example 1, the rotations of susceptor were varied in terms of the rectangular wave function, trapezoidal wave function and sine wave function as shown in Fig. 1 (A), (B) and (C), respectively, and, by depositivs of the buffer layer under the conditions shown in Table 1 through Table 3 and, in succession, by depositivs of the active layer under the conditions shown in Table 1 through Table 3 after the addition of $H_2S$ gas to source gases, the semiconductor thin films consisting of double layer structure of the buffer layer (15) and of the active layer (16) were deposited from vapor phase onto the substrates (5) as shown in Fig. 3.

Of the thin films obtained in this way, the thickness of the film in in the perpendicular direction to the flow of gas and the distribution of the carrier concentration inside the face of active layer were examined. As a result, the variations in the thickness of the film were less than $\pm$ 3 %, the distributions of the carrier concentration inside the face were uniform as indicated within $\pm$ 5 %, and the fluctuations of the carrier concentration in the direction of depth were not recognized in all cases.

Table 1 (Variarion in terms of the rectangular wave function)

|  | Buffer layer | Active layer |
|---|---|---|
| Deposition rate ($\mu$m/min) | 0.06 | 0.06 |
| Thickness ($\mu$m) | 3 | 0.3 |
| Deposition time (min) | 50 | 5 |
| Time constant (min) | $t_l = 5.0$ | $t_1 = 2.5$ |
| Number of rotations (rpm) | $r_0 = 6$ | $r_0 = 6$ |
| Number of rotations per a cycle (times) | 60 | 30 |
| Number of cycles | 5 | 1 |
| Total number of rotations (times) | 300 | 30 |

Table 2 (Variation in terms of the trapezoidal wave function)

|  | Buffer layer | Active layer |
|---|---|---|
| Deposition rate /$\mu$m/min) | 0.06 | 0.06 |
| Thickness ($\mu$m) | 3 | 0.3 |
| Deposition time (min) | 50 | 5 |
| Time constant (min) | $t_2 = 4.0$ | $t_2 = 1.5$ |
|  | $t_3 = 1.0$ | $t_3 = 1.0$ |
| Number of rotations (rpm) | $r_0 = 6$ | $r_0 = 6$ |
| Number of rotations per a cycle (times) | 54 | 24 |
| Number of cycles | 5 | 1 |
| Total number of rotations (times) | 270 | 24 |

Table 3 (Variation in terms of the sine wave function)

|  | Buffer layer | Active layer |
|---|---|---|
| Deposition rate (μm/min) | 0.06 | 0.06 |
| Thickness (μm) | 3 | 0.3 |
| Deposition time (min) | 50 | 5 |
| Time constant (min) | $t_4 = 5$ | $t_4 = 5$ |
| Number of rotations (rpm) | 5 | 5 |
| Number of rotations per a cycle (times) | 16 | 16 |
| Number of cycles | 10 | 1 |
| Total number of rotations (times) | 160 | 16 |

As described above, according to the invention, the discrepancy in the geometrical symmetry is averaged between the reaction tube and the susceptor and, at the same time, the uniformity of thin films deposited from vapor phase onto a plurality of substrates can be improved remarkably between the substrates and inside the subsrrate. Therefore, the invention exerts a conspicuous effect industrially.

**Claim**

A method for the chemical vapor deposition of semiconductor thin films on a plurality of substrates fitted to the side faces of a susceptor in the shape of a frustum rotate din a vertical type reaction tube by introducing the source gases and the carrier gas into said tube and heating the substrates to react with the source gases through thermal decomposition, characterized in that the speed of rotation of the susceptor is varied in terms of a rectangular wave function, trapezoidal wave function or a sine wave function and the susceptor is rotated in converse directions depending on the posititve region and the negative region of the function, wherein the time for deposition is made equal to the cycle of the rectangular wave function, trapezoidal wave function or sine wave function multiplied by an integer, and N = K, wherein N is the sum of the number of rotations of the susceptor in the respective positive regions of the function and K is the number of converse rotations of the susceptor in the respective negative regions of the function.

**Patentanspruch**

Verfahren zum chemischen Dampfabscheiden dünner Halbleiterschichten auf einer Vielzahl von Substraten, die auf den Seitenflächen einer Halterung in Form eines Kegelstumpfes, welcher sich in einem Reaktionsrohr des Senkrechttyps dreht, montiert sind, durch Einführen der Ausgangsgase und des Trägergases in das Rohr und Erhitzen der Substrate zur Umsetzung nut den Ausgangsgasen durch thermische Zersetzung, dadurch gekennzeichnet, daß die Drehgeschwindigkeit der Halterung in Form einer Rechteck-Wellenfunktion, Trapezoid-Wellenfunkuon oder einer Sinus-Wellenfunktion variert wird und die Halterung in bezug auf den positiven Abschnitt oder den negativen Abschnitt der Funktion in umgekehrter Richtung gedreht wird, wobei die Abscheidungszeit gleich is einem ganzahligen Vielfachen des Zyklus der Rechteck-Wellenfunktion, der Trapezoid-Wellenfunktion oder der Sinus-Wellenfunktion und N = K ist, wobei N die Summe der Anzahl der Umdrehungen der Halterung in denjeweiligen positiven Abschnitten der Funktion und K die Anzahl der umgekehrten Umdrehungen der Halterung in den jeweiligen negativen Abschnitten der Funktion bedeuten.

**Revendication**

Procédé de dépôt chimique en phase vapeur de films minces de semiconducteurs sur plusieurs substrats fixés sur les faces latérales d'une susceptance conique tournant dans un tube à réaction vertical, consistant à introduire les gaz sources et le gaz support à l'intérieur dudit tube et à chauffer les substrats pour les faire réagir avec les gaz sources par décomposition thermique, caractérisé en ce que la vitesse de rotation de la susceptance varie selon une fonction d'onde rectangulaire, trapézoïdale ou sinusoïdale, et la susceptance tourne dans des directions inverses selon que l'on se trouve dans la région positive ou négative de la fonction, le temps de dépôt étant égal au cycle de la fonction d'onde rectangulaire, trapézoïdale ou sinusoïdale multiplié par un nombre entier, et N = K, où N est la somme du nombre de rotations de la susceptance dans les régions positives respectives de la fonction et K est le nombre de rotations opposées de la susceptance dans les régions négatives respectives de la fonction.

5

# F I G . I

(A)

(B)

(C)

# FIG. 2

(A)

Gas

x

Thickness of film (μ)

Distance from left end of substrate x (cm)

(B)

Gas

x

Thickness of film (μ)

Distance from left end of substrate x (cm)

# F I G . 3

# F I G . 4

# F I G . 5

(A)

Thickness of film ($\mu$)

Distance from left end of substrate ( cm )

(B)

Thickness of film ($\mu$)

Distance from left end of substrate ( cm )